# DEMANDE DE BREVET EUROPEEN

(11) **EP 2 326 151 A1**
(43) Date de publication de la demande: **25.05.2011**
(21) Numéro de dépôt: 10153448.5
(22) Date de dépôt: 12.02.2010
(51) Int. Cl.: H05H 1/24

(54) **Procédé et dispositif de polarisation d'une électrode DBD**

(30) Priorité: 24.11.2009 EP 09176940
(71) Demandeur: AGC Glass Europe, 1170 Bruxelles (Watermael-Boitsfort) (BE)
(72) Inventeur: Michel, Eric, 6040 Jumet (BE); Tixhon, Eric, 6040 Jumet (BE); Leclercq, Joseph, 6040 Jumet (BE)
(74) Mandataire: Vandeberg, Marie-Paule L.G.

(57) **Abrégé**

Dispositif de traitement de surface par décharge à barrière diélectrique (DBD) comprenant un transformateur THT dans lequel une source de courant continu (DC) est intercalée dans le circuit secondaire du transformateur THT, de façon telle que des espèces chimiques sous formes d'ions électriquement positifs ou négatifs produits dans le plasma soient sélectivement attirées par un substrat cible et repoussés par les électrodes de charge correspondante.

## Description

### Domaine de l'invention

L'invention se rapporte à un procédé pour le dépôt de couches sur un substrat inorganique afin d'en modifier les propriétés. En particulier, l'invention vise le dépôt de couches sur des plaques de verre.

L'invention se rapporte aussi à une installation permettant d'appliquer le procédé en question, notamment en continu.

Différents procédés sont utilisés pour déposer des revêtements en couches minces sur des substrats divers. Ils se différencient notamment par la façon dont l'énergie est engendrée pour la production et/ou la liaison au support des composés souhaités.

Les dépôts de revêtements en couches minces touchent diverses applications, comme l'électronique, les revêtements anti-corrosion et tribologiques tels que les couches réfractaires (nitrures, carbures et oxydes de titane ou d'aluminium), les revêtements à propriétés optiques (anti-réfléchissants, anti-solaires, filtres, ..), les revêtements procurant d'autres propriétés de surface particulières(anti-microbienne,auto-nettoyante, hydrophile, hydrophobe etc.), les couches d'oxyde d'étain conductrices pour applications diverses (photovoltaïques, LED, OLED, organique photovoltaïque etc.).

Les substrats concernés peuvent être de divers types : verre, acier, céramique, polymères organiques, thermoplastiques...

On distingue principalement quatre techniques de dépôt de couches minces applicables en particulier dans le domaine verrier : le sol-gel, le magnétron, le spray pyrolytique, et le dépôt chimique en phase vapeur (CVD).

La CVD consiste à envoyer, sur un substrat chaud, des réactifs chimiques ou précurseurs, préalablement vaporisés et qui se décomposent par pyrolyse au contact du substrat chaud.

Ce procédé est couramment appliqué « on-line » lors de la production du verre flotté. On obtient ainsi des couches minces (de l'ordre de quelques dizaines ou centaines de nm), notamment d'oxydes. Les couches obtenues sont denses, d'une grande pureté et généralement très stables chimiquement ainsi que mécaniquement. Les vitesses de dépôt sont élevées.

Cependant, la gamme de matériaux pouvant être déposés est limitée car il est difficile de trouver des précurseurs volatilisables et qui vont pyrolyser dans la gamme de températures accessibles aux verriers (500-750°C). Une possibilité de s'affranchir de la température du substrat et donc d'élargir la gamme des précurseurs utilisables en CVD et, par conséquent, la gamme de matériaux déposable, est de combiner la CVD classique (éventuellement à plus basse température) avec un dispositif plasma.

La PECVD (pour « Plasma Enhanced Chemical Vapour Déposition ») peut s'effectuer à l'aide de n'importe quel plasma : plasmas froids (hors équilibre) ou plasmas thermiques (en équilibre). Les plasmas froids sont généralement préférés. Les espèces actives du plasma (électrons, ions, métastables,...) possèdent typiquement des énergies de plusieurs électronvolts (eV) et peuvent ainsi provoquer la dissociation ou l'activation des précurseurs chimiques.

Pour maintenir le plasma hors équilibre, il est souvent nécessaire de travailler à pression réduite. La plupart des techniques connues de PECVD utilisent donc des plasmas à basse pression. Cependant, pour appliquer ce procédé à des fins industrielles, il est nécessaire de minimiser les coûts. Il y a donc un intérêt croissant de la part des industriels pour transférer les technologies plasma basses pressions vers des technologies plasma fonctionnant dans une gamme de pression proche de la pression atmosphérique.

On distingue par ailleurs dans les procédés de dépôt sous plasma différents régimes : le régime sous plasma homogène (connu sous le nom de « glow dischage plasma»). Il permet des dépôts très homogènes et requiert un niveau d'énergie relativement bas. En revanche, il est plus lent, il faut le cantonner à une gamme de fréquence plus restreinte pour qu'il reste stable et il limite la composition des espèces que l'on peut déposer.

Si l'on augmente l'énergie du plasma, on risque de provoquer l'apparition d'arcs électriques. L'interposition d'un diélectrique entre les électrodes permet de maintenir un régime intermédiaire entre la « glow discharge » et l'apparition d'arcs: on parle de régime « filamentaire ». Les « filaments », éminemment instables, charrient une énergie élevée et permettent donc de raccourcir d'autant le temps de traitement, c'est-à-dire la d'accélérer le défilement du substrat. Par ailleurs, du fait même de l'action aléatoire des filaments, on obtient paradoxalement un taux de répartition très homogène des matériaux déposés.

On a cherché à allier les potentialités des procédés de traitement par CVD classique avec les potentialités d'un procédé plasma à pression atmosphérique. Le choix du Demandeur s'est porté sur l'utilisation d'une décharge à barrière diélectrique (DBD). Cette dernière a en effet l'avantage, par rapport aux autres procédés plasma, de fonctionner tant à basse pression qu'à pression atmosphérique et de permettre un traitement continu sur de grandes surfaces, ce qui implique que l'on puisse développer des puissances wattées de l'ordre du MégaWatt.

Lors de la formation du dépôt par le procédé DBD on constate que le dépôt est symétrique c'est à dire que la quantité de matière déposée sur le substrat et sur l'électrode est la même par unité de temps.

Le dépôt sur l'électrode est non désiré et constitue un frein important pour l'exploitation de ce procédé dans les applications industrielles de forte capacité car il perturbe rapidement la qualité de la couche déposée sur le substrat cible par la modification de l'espace inter-électrode qui constitue une donnée essentielle pour garantir la formation d'une couche homogène.

Des nettoyages fréquents seraient donc indispensables, entraînant des pertes de productivité ainsi qu'un dédoublement des installations de dépôt de couche dans les procédés de production continue pour permettre un nettoyage alterné.

Or, on constate que les espèces chimiques formées dans le plasma sont notamment sous forme d'ions positifs et négatifs. Cela revient à dire que les espèces chimiques qui interviennent dans le processus de formation de la couche sur le matériau à revêtir ne sont pas électriquement neutres.

### Résumé de l'invention

Un premier but de l'invention est de réduire, voir éliminer, les dépôts parasites sur l'électrode portée à la haute tension en polarisant cette dernière.

Un autre but est d'améliorer le rendement de procédés de dépôt de couches en augmentant la tension sur l'alternance durant laquelle les espèces désirées se déposent sur un substrat.

Un premier objet de l'invention est un procédé pour le dépôt d'une couche sur un substrat inorganique caractérisé en ce qu'il comprend les opérations suivantes .
- introduire ou faire défiler un substrat dans une chambre de réaction dans laquelle sont placées au moins deux électrodes, au moins une barrière diélectrique étant placée entre ces au moins deux électrodes;
- mettre en service une alimentation stabilisée en amplitude et en fréquence comprenant un transformateur haute fréquence (HF) aux bornes du secondaire duquel les au moins deux électrodes sont reliées ;
- engendrer dans le circuit secondaire de ce transformateur une tension électrique à haute fréquence stabilisée de valeur telle qu'elle entraîne la génération d'un plasma filamentaire entre les au moins deux électrodes ;
- mettre en service une alimentation DC de manière à polariser l'électrode portée à la haute tension.
- introduire dans la chambre de réaction un mélange dont la composition est telle qu'au contact du plasma, il se décompose et engendre des espèces aptes à se déposer en couche en grande partie ou en totalité sur le substrat ;
- maintenir le substrat dans la chambre durant un laps de temps suffisant pour obtenir sur au moins une de ses faces une couche d'épaisseur souhaitée.

On notera que le procédé de l'invention est défini en termes d' « opérations » plutôt que d' « étapes », c'est à dire que la succession des opérations ne s'effectue pas obligatoirement dans l'ordre où elles sont énoncées ci-dessus.

Un autre objet de l'invention est un dispositif de traitement de surface par décharge à barrière diélectrique (DBD) comprenant un transformateur THT dans lequel une source de courant continu (DC) est intercalée dans le circuit secondaire du transformateur THT, de façon telle que des espèces chimiques sous formes d'ions électriquement positifs ou négatifs produits dans le plasma soient sélectivement attirées par un substrat cible et repoussés par les électrodes de charge correspondante.

La source DC est avantageusement insérée en série avec le secondaire du transformateur THT.

Suivant une autre forme de réalisation avantageuse, la source DC est insérée en parallèle avec le secondaire du transformateur THT.

De préférence, la source DC intercalée dans le circuit HF du transformateur THT est comprise entre 1 KV et 15 KV.

Suivant une forme de réalisation avantageuse, la source DC est obtenue à l'aide d'un circuit redresseur alimenté directement par une fraction de la tension HF prélevée au générateur THT.

Le dispositif comprend de préférence un commutateur permettant de permuter les pôles positif et négatif afin de polariser l'électrode soit positivement soit négativement par rapport au substrat cible.

Des moyens d'ajustement de la tension de polarisation sont avantageusement prévus, de façon telle que la dite tension ne permette plus l'amorçage du plasma que sur une demi alternance positive ou négative, la polarisation étant telle que le plasma génère les espèces chimiquement responsable du dépôt de couche que lorsque l'électrode est de signe contraire à ces dites espèces.

Les pôles de la source DC sont avantageusement court-circuités par une capacité dont l'impédance est au moins 1000 fois plus faible que celle constituée par la cellule de décharge.

Avantageusement, une capacité de blocage est placée directement en série avec le transformateur afin d'éviter que la composante continue du courant ne puisse perturber le fonctionnement de ce transformateur THT.

Un premier avantage du procédé et du dispositif de l'invention est que la diminution, voire l'élimination de dépôts parasites sur l'électrode portée à la haute tension n'engendre pas de perturbation au niveau de la décharge plasma (modification des constantes diélectriques, de l'espace inter-électrodes...) et qu'il n'est plus nécessaire d'interrompre le procédé afin de réaliser à un nettoyage de l'électrode.

Un autre avantage du procédé de l'invention est que la polarisation de l'électrode portée à la haute tension permet d'appliquer un surcroît de tension sur l'alternance durant laquelle le dépôt de couche s'effectue sur le substrat. Ce surcroît de tension permet, pour une distance inter-électrode donnée, d'augmenter le rendement matière ainsi que les vitesses de dépôt. Il permet également, pour une vitesse de dépôt ou un rendement matière donnés, d'augmenter l'espace qui sépare les électrodes.

### Brève description des figures

Ces aspects ainsi que d'autres aspects de l'invention seront clarifiés dans la description détaillée de modes de réalisation particuliers de l'invention, référence étant faite aux dessins des figures, dans lesquelles .
La Fig.1 est un schéma simplifié d'un mode de polarisation série ;
La Fig.2 est un schéma simplifié d'un mode de polarisation parallèle ;
La Fig.3 est un schéma simplifié d'un mode de polarisation avec prélèvement de tension sur le secondaire du transformateur et redressement ;
La Fig. 4 est un graphique montrant l'effet de superposition des deux tensions continue et alternative.

Les figures ne sont pas dessinées à l'échelle. Généralement, des éléments semblables sont dénotés par des références semblables dans les figures.

### Description détaillée de modes de réalisation particuliers

L'invention concerne un procédé et un dispositif de polarisation en courant continu (DC) d'une cellule d'un dispositif de décharge à barrière diélectrique (DBD) permettant de réduire ou d'annuler tout dépôt non souhaité sur une des électrodes de cette cellule. L'électrode est utilisée pour la génération du plasma produisant des espèces chimiques sous formes d'ions électriquement positifs ou négatifs formant par déposition une couche sur un substrat cible, qui est par exemple un volume de verre.

Cette fonction peut être améliorée par une polarisation DC de l'électrode, ce qui permet de réduire ou d'annuler tout dépôt non souhaité sur la dite électrode. En effet, la polarisation de l'électrode portée à haute tension permet de repousser les charges électriques de même signe et donc de réduire la formation d'un dépôt non désiré sur cette électrode. En effet, dans ce cas, seules les espèces (en général des molécules ionisées) de signe opposé à celui de l'électrode sont attirées par celle-ci et peuvent s'y déposer, ce qui ralentit considérablement le dépôt non désiré.

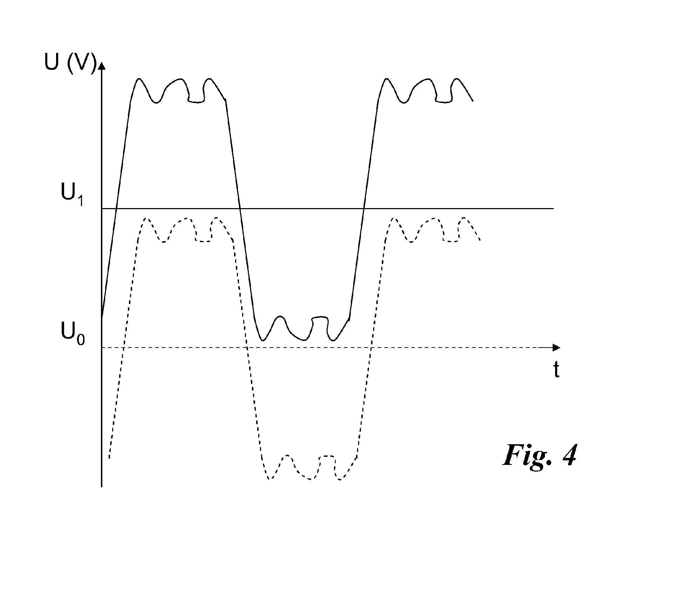

Comme montré à la Fig.4, la tension de polarisation peut être ajustée de sorte qu'elle ne permette plus l'amorçage du plasma que sur une demi alternance (positive ou négative). Ceci est rendu possible en appliquant une polarisation telle que la tension résultante entre l'électrode haute tension et la masse soit inférieure à la tension d'amorçage du plasma. Dès lors, il est possible d'éviter tout dépôt lié à la demi-alternance positive ou négative. Les espèces chimiques responsables du dépôt de couche n'étant plus générées pendant la demi-période durant laquelle elles sont attirées vers l'électrode, le dépôt parasite est pratiquement supprimé.

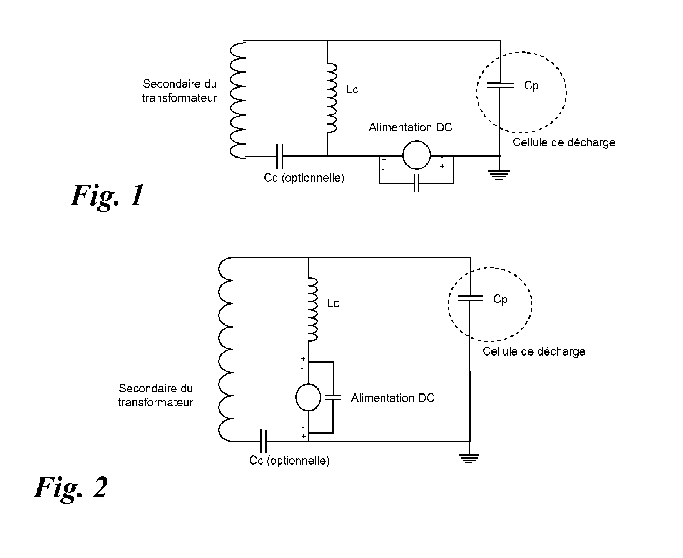

Cette polarisation est obtenue en intercalant dans le circuit haute fréquence (HF) une source DC comprise entre 1 KV et 15 KV. Plus précisément, la source DC est intercalée entre la masse (commune avec la mise à la terre) et la jonction « froide » du secondaire du transformateur haute tension et de la self de compensation. (Comme montré aux figures 1 et 2). Dans certaines situations, afin d'éviter que la composante continue ne puisse perturber le fonctionnement du transformateur haute tension (THT) en provoquant la saturation magnétique de son noyau en ferrite, il est avantageux d'intercaler une capacité de blocage Cc placée directement en série avec le transformateur.

La source DC à des pôles flottants pour permettre, suivant les différents types de couche, une polarisation positive ou négative. Les pôles positif et négatif peuvent être commutés afin de polariser l'électrode soit positivement soit négativement par rapport au substrat cible. Les pôles de la source DC sont shuntés par une capacité dont l'impédance est au moins 1000 fois plus faible que la capacité de la cellule de décharge, qui est en fait l'équivalent électrique de la chambre à plasma où se déroulent les opérations de traitement de surface. La capacité en parallèle sur l'alimentation DC a une valeur telle que son impédance soit nettement inférieure à celle de la cellule de décharge afin de ne pas perturber le fonctionnement du circuit résonnant formé par le couplage entre la partie capacitive du système (Cp) et la partie inductive des selfs de compensation (Lc).

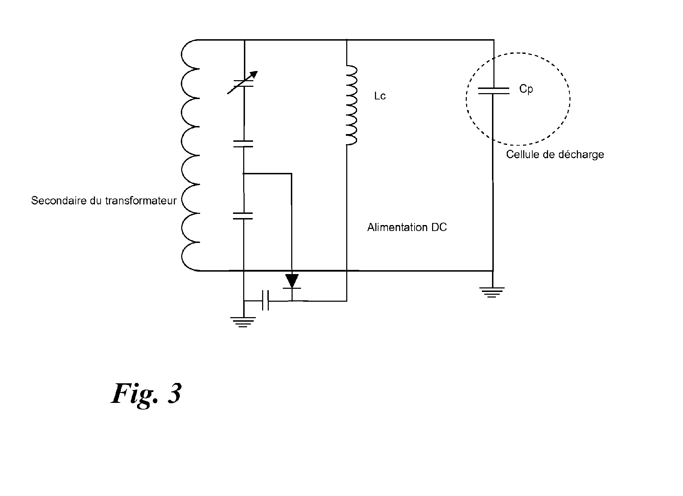

Dans le cas d'installations de forte puissance, nécessaires aux cadences de production élevée, il peut être avantageux de générer la tension DC de polarisation en prélevant une fraction de la tension haute fréquence. Comme cela est représenté à la Fig. 3, la source DC est obtenue à l'aide d'un circuit redresseur alimenté directement par une fraction de la tension HF prélevée au générateur THT.

Il apparaîtra évident pour l'homme du métier que la présente invention n'est pas limités aux exemples illustrés et décrits ci-dessus. L'invention comprend chacune des caractéristiques nouvelles ainsi que leur combinaison. La présence de numéros de référence ne peut être considérée comme limitative. L'usage du terme « comprend » ne peut en aucune façon exclure la présence d'autres éléments autres que ceux mentionnés. L'usage de l'article défini « un » pour introduire un élément n'exclut pas la présence d'une pluralité de ces éléments. La présente invention a été décrite en relation avec des modes de réalisations spécifiques, qui ont une valeur purement illustrative et ne doivent pas être considérés comme limitatifs

## Revendications

1. Dispositif de traitement de surface par décharge à barrière diélectrique (DBD) comprenant un transformateur THT **caractérisé en ce qu'**une source de courant continu (DC) est intercalée dans le circuit secondaire du transformateur THT, de façon telle que des espèces chimiques sous formes d'ions électriquement positifs ou négatifs produits dans le plasma soient sélectivement attirées par un substrat cible et repoussés par les électrodes de charge correspondante.

2. Dispositif suivant la revendication 1, **caractérisé en ce que** la source DC est insérée en série avec le secondaire du transformateur THT.

3. Dispositif suivant la revendication 1, **caractérisé en ce que** la source DC est insérée en parallèle avec le secondaire du transformateur THT.

4. Dispositif suivant l'une quelconque des revendications 1 à 3, **caractérisé en ce que** la source DC intercalée dans le circuit HF du transformateur THT est comprise entre 1 KV et 15 KV.

5. Dispositif suivant l'une quelconque des revendications précédente, caractérisé en ce la source DC est obtenue à l'aide d'un circuit redresseur alimenté directement par une fraction de la tension HF prélevée au générateur THT.

6. Dispositif suivant l'une quelconque des revendications précédentes, **caractérisé en ce qu'**il comprend un commutateur permettant de permuter les pôles positif et négatif afin de polariser l'électrode soit positivement soit négativement par rapport au substrat cible.

7. Dispositif suivant l'une quelconque des revendications précédentes, **caractérisé en ce qu'**il comprend des moyens d'ajustement de la tension de polarisation de façon telle que la dite tension ne permette plus l'amorçage du plasma que sur une demi alternance positive ou négative, la polarisation étant telle que le plasma génère les espèces chimiquement responsable du dépôt de couche que lorsque l'électrode est de signe contraire à ces dites espèces.

8. Dispositif suivant l'une quelconque des revendications précédente, **caractérisé en ce que** les pôles de la source DC sont court-circuités par une capacité dont l'impédance est au moins 1000 fois plus faible que celle constituée par la cellule de décharge.

9. Dispositif suivant l'une des revendications précédente, **caractérisé en ce qu'**une capacité de blocage est placée directement en série avec le transformateur afin d'éviter que la composante continue du courant ne puisse perturber le fonctionnement de ce transformateur THT.

10. Procédé pour le dépôt d'une couche sur un substrat inorganique **caractérisé en ce qu'**il comprend les opérations suivantes .
- introduire ou faire défiler un substrat dans une chambre de réaction dans laquelle sont placées au moins deux électrodes, au moins une barrière diélectrique étant placée entre ces au moins deux électrodes;
- mettre en service une alimentation stabilisée en amplitude et en fréquence comprenant un transformateur haute fréquence (HF) aux bornes du secondaire duquel les au moins deux électrodes sont reliées ;
- engendrer dans le circuit secondaire de ce transformateur une tension électrique à haute fréquence stabilisée de valeur telle qu'elle entraîne la génération d'un plasma filamentaire entre les au moins deux électrodes ;
- mettre en service une alimentation DC de manière à générer une tension continue qui se superpose à la tension alternative générée par le transformateur, de façon à augmenter la polarité du substrat et de diminuer la polarité de l'électrode ou réciproquement suivant la valeur de la tension alternative ;
- introduire dans la chambre de réaction un mélange dont la composition est telle qu'au contact du plasma, il se décompose et engendre des espèces aptes à se déposer en couche en grande partie ou en totalité sur le substrat ;
- maintenir le substrat dans la chambre durant un laps de temps suffisant pour obtenir sur au moins une de ses faces une couche d'épaisseur souhaitée.

11. Procédé suivant la revendication 10 **caractérisé en ce qu'**il comprend en outre les opérations suivantes .
- ajuster la valeur de la source DC de façon à ce que la tension alternative n'atteigne pas la valeur d'amorçage dans un des sens de la polarité.

12. Procédé selon l'une quelconque des revendications 10 ou 11, **caractérisé en ce qu'**il comprend l'inversion de la polarité par rapport au substrat.
